# FASCICULE DE BREVET EUROPEEN

(11) **EP 3 815 242 B1**
(45) Date de publication et mention de la délivrance du brevet: **30.11.2022**
(21) Numéro de dépôt: 19726699.2
(22) Date de dépôt: 28.05.2019
(51) Int. Cl.: H02P 29/02, H02P 27/06

(54) **SYSTÈME DE COMMANDE D'UN INTERRUPTEUR ET BRAS DE COMMUTATION**
SYSTEM ZUR STEUERUNG EINES SCHALTERS UND SCHALTARM
SYSTEM FOR CONTROLLING A SWITCH AND SWITCHING ARM

(30) Priorité: 28.06.2018 FR 1855893
(43) Date de publication de la demande: 05.05.2021
(73) Titulaire: VALEO EQUIPEMENTS ELECTRIQUES MOTEUR, 94046 Créteil Cedex (FR)
(72) Inventeur: MORVANY, Romuald, 94046 CRETEIL CEDEX (FR)
(74) Mandataire: Valeo Powertrain Systems
(86) Numéro de dépôt international: PCT/EP2019/063804
(87) Numéro de publication internationale: WO 2020/001900

(56) Documents cités:
- FR-A1- 3 047 854
- JP-A- S5 851 793
- US-A- 4 123 779
- US-A- 4 272 709
- US-A1- 2009 140 677
- US-A1- 2016 276 956

## Description

### DOMAINE TECHNIQUE

La présente invention concerne un système de commande d'un interrupteur et un bras de commutation.

### ARRIÈRE-PLAN TECHNOLOGIQUE

Il est connu d'utiliser (voir le document US2009/140677-A1) un système de commande d'un interrupteur, du type comportant un amplificateur conçu pour recevoir un signal de commande d'entrée, pour amplifier le signal de commande d'entrée afin d'obtenir un signal de commande de sortie et pour appliquer le signal de commande de sortie à l'interrupteur pour sélectivement ouvrir et fermer l'interrupteur, l'amplificateur présentant deux bornes d'alimentation positive et négative destinées à recevoir une tension d'alimentation.

Un système de commande du type précité est par exemple utilisé pour commander les deux interrupteurs d'un bras de commutation d'un convertisseur de tension connecté à une machine électrique tournante.

Or, dans le système de commande du type précité, l'état ouvert ou fermé de l'interrupteur est défini par le signal de commande d'entrée.

Ainsi, en cas de défaillance du dispositif générant le signal de commande d'entrée, il n'est plus possible de contrôler l'état de l'interrupteur. Dans le cas du bras de commutation, il n'est donc plus possible d'ouvrir les deux interrupteurs afin de placer la machine électrique tournante dans un état sécurisé.

L'invention a pour but de pallier au moins en partie les problèmes précités.

### RÉSUMÉ DE L'INVENTION

À cet effet, il est proposé un système de commande du type précité, caractérisé en ce qu'il comporte en outre un dispositif d'inhibition de l'amplificateur conçu, sur réception d'une commande d'inhibition dite totale, pour faire baisser la tension d'alimentation de sorte que le signal de commande de sortie maintienne l'interrupteur ouvert quel que soit le signal de commande d'entrée.

Grâce à l'invention, il est possible d'ouvrir l'interrupteur indépendamment du signal de commande d'entrée reçu par l'amplificateur, et donc indépendamment du bon fonctionnement ou non du dispositif fournissant ce signal de commande d'entrée. Ainsi, dans le cas d'un bras de commutation, il est toujours possible d'ouvrir les deux interrupteurs.

De façon optionnelle, le dispositif d'inhibition est conçu, sur réception de la commande d'inhibition totale, pour mettre les bornes d'alimentation de l'amplificateur en court-circuit.

De façon optionnelle également, le dispositif d'inhibition comporte un interrupteur commandable de court-circuit présentant une borne d'entrée de courant connectée à la borne d'alimentation positive, une borne de sortie de courant connectée à la borne d'alimentation négative, et une borne de commande, la commande d'inhibition totale étant sous la forme d'une tension entre la borne de commande et la borne de sortie de courant.

De façon optionnelle également, le système de commande comporte en outre un dispositif de décalage de niveau conçu pour recevoir la commande d'inhibition totale sous la forme d'une tension par rapport à une référence de tension différente de la borne négative de l'amplificateur et pour fournir la commande d'inhibition totale au dispositif d'inhibition sous la forme d'une tension par rapport à la borne négative de l'amplificateur.

De façon optionnelle également, le système de commande comporte en outre une capacité connectée entre les bornes positive et négative de l'amplificateur pour fournir la tension d'alimentation.

De façon optionnelle également, le système de commande comporte en outre un dispositif de charge de la capacité.

Il est également proposé un système de bras de commutation d'un convertisseur de tension, comportant :
- un interrupteur de côté haut,
- un interrupteur de côté bas,
- un système de commande de l'un parmi les interrupteurs de côté haut et de côté bas, selon l'invention,
dans lequel l'interrupteur de côté haut et l'interrupteur de côté bas sont connectés l'un à l'autre en un point milieu destiné à être connecté à une phase d'une machine électrique tournante.

De façon optionnelle, le système de bras de commutation comporte en outre un système de commande de l'autre parmi les interrupteurs de côté haut et de côté bas, selon l'invention.

De façon optionnelle également, le système de bras de commutation comporte une seule entrée de réception de la commande d'inhibition totale destinée à la fois au système de commande de l'interrupteur de côté haut et au système de commande de l'interrupteur de côté bas.

### DESCRIPTION DES FIGURES

La figure 1 est un schéma électrique simplifié d'un système électrique 100 selon l'invention comportant une source de tension continue, une machine électrique tournante, et un convertisseur de tension intercalé entre eux.
La figure 2 est un schéma fonctionnel d'un système de commande du convertisseur de tension de la figure 1.
La figure 3 est un schéma électrique illustrant les éléments du système de commande permettant d'ouvrir un interrupteur du convertisseur de tension, indépendamment des signaux de commande de cet interrupteur.

### DESCRIPTION DÉTAILLÉE

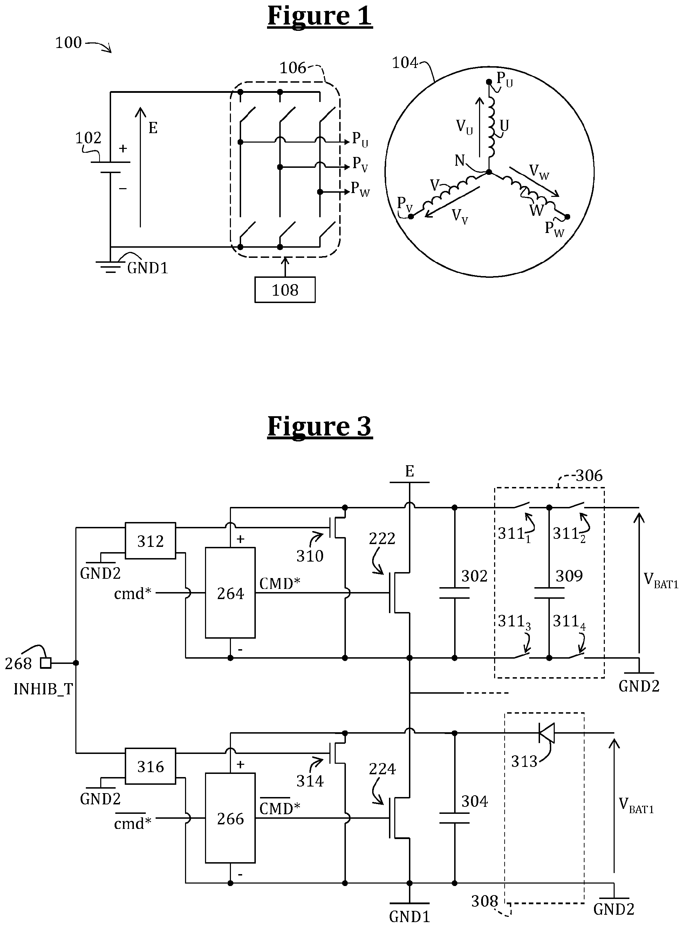

En référence à la figure 1, un système électrique 100 selon l'invention va à présent être décrit. Le système électrique 100 est par exemple destiné à être implémenté dans un véhicule automobile.

Le système électrique 100 comporte tout d'abord une source de tension continue 102 comportant une borne positive et une borne négative, cette dernière étant généralement connectée à une masse électrique, notée GND1 (de l'anglais « ground ») sur les figures, telle qu'un châssis du véhicule automobile. La source de tension continue 102 est conçue pour fournir une tension d'entrée E continue entre ces bornes, valant par exemple autour de 12 V.

Le système électrique 100 comporte en outre une machine électrique tournante 104 comportant des phases statoriques U, V, W dont, dans l'exemple décrit, des premières extrémités respectives sont connectées à un même point neutre N. Dans l'exemple décrit, la machine électrique tournante 104 fait partie d'un alterno-démarreur couplé à un moteur thermique (non représenté) du véhicule automobile. La machine électrique tournante 104 est ainsi conçue pour fonctionner alternativement en mode moteur dans lequel elle assiste le moteur thermique et en mode alternateur dans lequel elle transforme une partie de l'énergie mécanique générée par le moteur thermique en énergie électrique pour recharger la source de tension continue 102.

Le système électrique 100 comporte en outre un convertisseur de tension 106 connecté, d'une part, aux bornes de la source de tension continue 102 et, d'autre part, à la machine électrique tournante 104.

Le convertisseur de tension 106 comporte des bras de commutation respectivement associés aux phases statoriques U, V, W. Chaque bras de commutation comporte un interrupteur de côté haut connecté à la borne positive de la source de tension continue 102 et un interrupteur de côté bas connecté à la borne négative de la source de tension continue 102. L'interrupteur de côté haut et l'interrupteur de côté bas sont en outre connectés l'un à l'autre en un point milieu connecté à la phase statorique U, V, W associée. Chaque bras de commutation est destiné à être commandé pour commuter entre deux configurations. Dans la première, dite configuration haute, l'interrupteur de côté haut est fermé et l'interrupteur de côté bas est ouvert de sorte que la tension d'entrée E est appliquée à une deuxième extrémité de la phase statorique U, V, W associée. Dans la deuxième, dite configuration basse, l'interrupteur de côté haut est ouvert et l'interrupteur de côté bas est fermé de sorte qu'une tension nulle est appliquée à la deuxième extrémité de la phase statorique U, V, W associée.

Le convertisseur de tension 106 est destiné à être commandé pour faire commuter chaque bras entre ces deux configurations, de manière à fournir de l'énergie électrique à la machine électrique tournante 104 lorsqu'il est souhaité qu'elle fonctionne en mode moteur et pour fournir de l'énergie électrique à la source de tension continue 102 lorsqu'il est souhaité que la machine électrique tournante 104 fonctionne en mode alternateur.

Ainsi, le système électrique 100 comporte en outre un système de commande 108 du convertisseur de tension 106, qui sera décrit en détail ci-dessous.

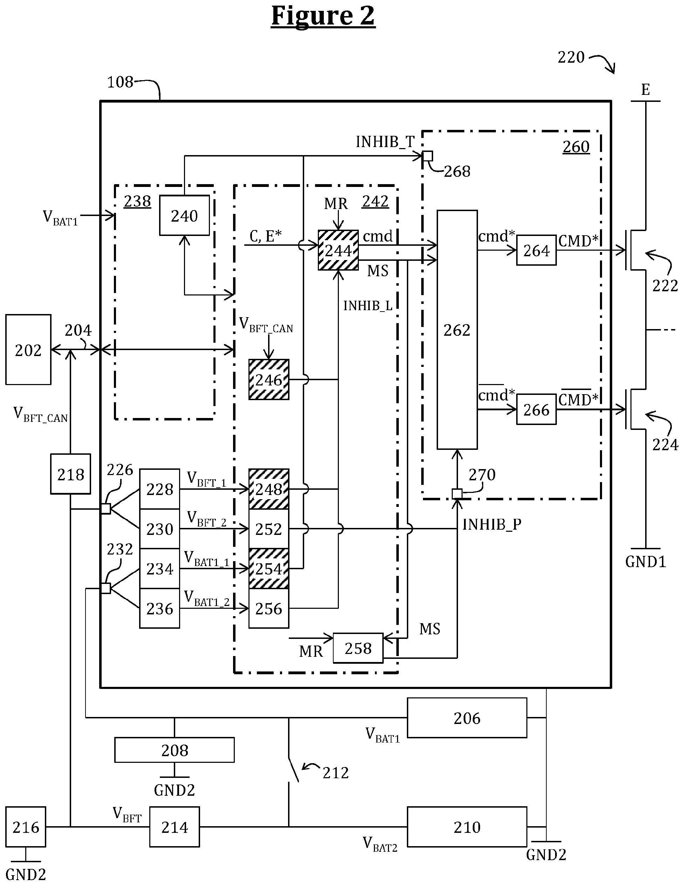

En référence à la figure 2, le système électrique 100 comporte en outre une unité de commande électronique 202 (de l'anglais « Electronic Control Unit » ou ECU) et un bus de données 204, dans l'exemple décrit un bus de données CAN (de l'anglais « Controller Area Network ») interconnectant l'unité de commande électronique 202 et le système de commande 108.

Le système électrique 100 comporte en outre une source de tension continue 206 conçue pour fournir une tension continue V_{BAT1} par rapport à une masse électrique, notée GND2 sur les figures et généralement connectée au châssis du véhicule automobile. Dans l'exemple décrit, la source de tension continue 206 comporte une batterie Li-ion et la tension V_{BAT1} vaut par exemple autour de 12 V. La source de tension 102 fournissant la tension E utilise par exemple la source de tension 206, de sorte que la tension E est dérivée de la tension V_{BAT1}.

Le système électrique 100 comporte en outre un démarreur 208 conçu pour aider le moteur thermique du véhicule automobile à démarrer, lorsque l'alterno-démarreur n'en est pas capable, par exemple lorsque la température du moteur thermique est trop faible.

Le système électrique 100 comporte en outre une source de tension continue 210 conçue pour fournir une tension continue V_{BAT2} par rapport à la masse électrique GND2. Dans l'exemple décrit, la source de tension continue 210 comporte une batterie au plomb (« lead acid battery » en anglais) et la tension V_{BAT2} vaut par exemple autour de 12 V.

Le système électrique 100 comporte en outre un interrupteur commandable 212 destiné, lorsqu'il est fermé, à connecter entre elles les deux sources de tension continue 206, 210 afin qu'elles coopèrent pour fournir suffisamment de courant au démarreur 208 lorsqu'il fonctionne.

Le système électrique 100 comporte en outre une borne de fusible de batterie 214 (de l'anglais « Battery Fuse Terminal» ou BFT) connectée à la source de tension continue 210 pour fournir une tension V_{BFT}, sensiblement égale à la tension V_{BAT2} et donc valant autour de 12 V dans l'exemple décrit.

Le système électrique 100 comporte en outre des composants électriques 216 connectés à la borne de fusible de batterie 214 pour recevoir la tension V_{BFT} et ainsi être alimentés électriquement.

La borne de fusible de batterie 214 comporte au moins un fusible (non représenté) destiné à interrompre la connexion avec la source de tension continue 210 lorsque le courant traversant ce fusible devient trop important, par exemple en cas de court-circuit d'un des composants électriques 216

Le système électrique 100 comporte en outre un capteur de tension 218 conçu pour fournir une mesure V_{BFT_CAN} de la tension V_{BFT} au bus de données 204.

Le système de commande 108 va à présent être décrit plus en détail, pour la commande d'un bras de commutation du convertisseur de tension 106 de la figure 1. Ce bras de commutation, désigné par la référence 220, comporte, comme expliqué ci-dessus en référence à la figure 1, un interrupteur de côté haut, désigné par la référence 222, et un interrupteur de côté bas, désigné par la référence 224. L'interrupteur de côté haut 222 présente une borne d'entrée de courant connectée à la borne positive de la source de tension continue 102, une borne de sortie de courant connectée au point milieu du bras de commutation 220 et une borne de commande. L'interrupteur de côté bas 224 présente une borne d'entrée de courant connectée au point milieu, une borne de sortie de courant connectée à la masse électrique GND1 et une borne de commande.

Le système de commande 108 comporte tout d'abord une entrée 226 connectée à la borne de fusible de batterie 214 pour recevoir la tension V_{BFT}.

Le système de commande 108 comporte en outre deux capteurs 228, 230 connectés à l'entrée 226 et conçus pour respectivement fournir deux mesures V_{BFT_1}, V_{BFT_2} de la tension V_{BFT}.

Le système de commande 108 comporte en outre une entrée 232 connectée à la source de tension continue 206 pour recevoir la tension V_{BAT1}.

Le système de commande 108 comporte en outre deux capteurs 234, 236 connectés à l'entrée 232 et conçus pour respectivement fournir deux mesures V_{BAT1_1}, V_{BAT1_2} de la tension V_{BAT1}.

Le système de commande 108 comporte en outre un microcontrôleur 242 et un pilote 260 qui vont à présent être décrits. Il est par exemple prévu un pilote (similaire au pilote 260) pour chaque bras de commutation du convertisseur de tension 106 et un seul microcontrôleur 242 pour tous les pilotes.

Comme cela est connu en soit, le microcontrôleur 242 est un dispositif informatique muni d'une unité de traitement et d'une mémoire principale (non représentées). Un ou plusieurs programmes d'ordinateur sont enregistrés dans la mémoire principale et destinés à être exécutés par l'unité de traitement pour implémenter les dispositifs qui vont à présent être décrits.

Ainsi, le microcontrôleur 242 implémente tout d'abord un dispositif d'établissement de commandes 244.

Le dispositif d'établissement de commandes 244 est tout d'abord conçu pour recevoir, depuis le bus de données 204, une requête de mode (de l'anglais « mode request »), notée MR sur les figures, indiquant le mode dans lequel doit être commandé le convertisseur de tension 106 : mode alternateur ou bien mode moteur. Le dispositif d'établissement de commandes 244 est ainsi conçu pour fonctionner sélectivement en mode moteur et en mode alternateur suivant la requête de mode MR reçue du bus de données 204.

Le dispositif d'établissement de commandes 244 est conçu pour établir des commandes, notées cmd sur les figures, à destination du pilote 260, ces commandes cmd étant adaptées au mode dans lequel il se trouve. Plus précisément, en mode moteur, le dispositif d'établissement de commandes 244 est conçu pour établir les commandes cmd à partir d'un couple cible C souhaité en bout d'arbre de la machine électrique tournante 104. En mode alternateur, le dispositif d'établissement de commandes 244 est conçu pour établir les commandes cmd en fonction d'une tension cible E^{∗} pour la tension E. Le couple cible C et la tension cible E^{∗} sont par exemple reçus du bus de données 204.

Le dispositif d'établissement de commandes 244 est en outre conçu pour transmettre la requête de mode MR au pilote 260. Pour différencier la requête de mode MR reçue de celle transmise, cette dernière est appelée sélection de mode et notée MS (de l'anglais « mode selection ») sur les figures.

Le dispositif d'établissement de commandes 244 est en outre conçu, tant qu'il reçoit une commande d'inhibition, dite logicielle et notée INHIB_L, pour fournir au pilote 260 des commandes cmd destinées à entraîner l'ouverture des interrupteurs 222, 224 indépendamment des consignes reçues (C, E^{∗}).

Le microcontrôleur 242 implémente en outre un dispositif de surveillance 246 de la mesure V_{BFT_CAN}, conçu pour fournir une commande d'inhibition logicielle INHIB_L au dispositif de d'établissement de commandes 244 lorsque la mesure V_{BFT_CAN} passe sous un seuil prédéfini. Dans l'exemple décrit, ce seuil prédéfini est compris entre 8 V et 11 V, par exemple 10,8 V.

Le microcontrôleur 242 implémente en outre un dispositif de surveillance 248 de la mesure V_{BFT_1}, conçu pour fournir une commande d'inhibition logicielle INHIB_L au dispositif d'établissement de commandes 244 lorsque la mesure V_{BFT_1} passe sous un seuil prédéfini. Dans l'exemple décrit, ce seuil prédéfini est compris entre 8 V et 11 V, par exemple 10,8 V.

Le microcontrôleur 242 implémente en outre un dispositif de surveillance 252 de la mesure V_{BFT_2}, conçu pour fournir une commande d'inhibition dite partielle et notée INHIB_P au pilote 260 lorsque la mesure V_{BFT_2} passe sous un seuil prédéfini. Dans l'exemple décrit, ce seuil prédéfini est compris entre 8 V et 11 V, par exemple 10,8 V.

Le microcontrôleur 242 implémente en outre un dispositif de surveillance 254 de la mesure V_{BAT1_1}, conçu pour fournir une commande d'inhibition dite totale et notée INHIB_T au pilote 260 lorsque la mesure V_{BAT1_1} passe sous un seuil prédéfini. Dans l'exemple décrit, ce seuil prédéfini est compris entre 5 V et 8 V, par exemple 5,5 V.

Le microcontrôleur 242 implémente en outre un dispositif de surveillance 256 de la mesure V_{BAT1_2}, conçu pour fournir une commande d'inhibition logicielle INHIB_L au dispositif d'établissement de commandes 244 lorsque la mesure V_{BAT1_2} passe sous un seuil prédéfini. Dans l'exemple décrit, ce seuil prédéfini est compris entre 5 V et 8 V, par exemple 5,5 V.

Il sera apprécié que le seuil prédéfini pour les mesures de la tension V_{BFT} est supérieur au seuil prédéfini pour les mesures de la tension V_{BAT1}. En effet, une batterie Li-ion risque de prendre feu et/ou de dégager des gaz toxiques en cas de sous-tension, même peu importante. En revanche, un tel risque est très modéré pour une batterie au plomb de sorte qu'une sous-tension plus importante peut être tolérée.

Le microcontrôleur 242 implémente en outre un dispositif de détection de démarrage intempestif 258. Un démarrage intempestif risque d'intervenir lors d'une défaillance du microcontrôleur 242. Dans ce cas, le microcontrôleur 242 défaillant risque de passer en mode moteur et d'envoyer au pilote 260 une sélection de mode MS indiquant de passer en mode moteur alors que la requête de mode MR reçue indique d'utiliser le mode alternateur (le véhicule automobile est arrêté). Ainsi, le dispositif de détection de démarrage intempestif 258 est conçu pour détecter lorsque la sélection de mode MS indique un mode moteur alors que la requête de mode MR indique un mode alternateur. Dans ce cas, le dispositif de détection de démarrage intempestif 258 est conçu pour envoyer une commande d'inhibition partielle INHIB_P au pilote 260.

Pour s'assurer que le dispositif de détection de démarrage intempestif 258 reçoit bien la sélection de mode MS envoyée par le microcontrôleur 242, le dispositif de détection de démarrage intempestif 258 est conçu pour surveiller une broche d'entrée du microcontrôleur 242 connectée à une broche de sortie du microcontrôleur 242 connectée au pilote 260 et présentant la sélection de mode MS.

Par ailleurs, dans l'exemple décrit, le microcontrôleur 242 présente deux niveaux d'exécution au moins en partie structurellement séparés, appelés niveau fonctionnel (de l'anglais « functional level ») et niveau de surveillance (de l'anglais « monitoring level »). Les dispositifs 244, 246, 248, 254 sont mis en œuvre dans le niveau fonctionnel du microcontrôleur 242, ce qui est indiqué sur la figure 2 par des hachures, tandis que les dispositifs 252, 256, 258 sont mis en œuvre dans le niveau de surveillance du microcontrôleur 242, ce qui est indiqué sur la figure 2 par l'absence de hachures. La séparation structurelle peut utiliser deux mécanismes (pouvant être mises en œuvre en même temps). Selon le premier mécanisme, l'unité de traitement comporte deux cœurs distincts respectivement dédiés aux deux niveaux. Ainsi, le microcontrôleur 242 est conçu pour que les dispositifs de chacun des deux niveaux soient exécutés exclusivement par le cœur associé à ce niveau et non par l'autre cœur. Selon le deuxième mécanisme, deux plages mémoire prédéfinies de la mémoire principale sont respectivement dédiées aux deux niveaux. Ainsi, le microcontrôleur 242 est conçu pour que les dispositifs de chacun des deux niveaux utilisent exclusivement la plage mémoire associée à ce niveau et non l'autre plage mémoire.

Le système de commande 108 comporte en outre un dispositif de surveillance 240 (« watchdog » en anglais) du microcontrôleur 242. Ce dispositif de surveillance 240 est conçu pour fournir une commande d'inhibition totale INHIB_T au pilote 260 en cas de détection d'une défaillance du microcontrôleur 242.

Le pilote 260 va à présent être décrit plus en détail. Dans l'exemple décrit, le pilote 260 est implémenté au moins en partie par un circuit intégré spécifique (de l'anglais « Application-specific integrated circuit » ou ASIC).

Le pilote 260 comporte un dispositif de gestion de commandes 262 et deux amplificateurs respectivement de côté haut 264 et de côté bas 266.

Le dispositif de gestion de commandes 262 est conçu pour recevoir, du microcontrôleur 242, les commandes cmd et pour fournir des signaux de commande d'entrée cmd^{∗}, c̅m̅d̅^{∗} respectivement aux deux amplificateurs 264, 266 à partir des commandes cmd. Les signaux de commande d'entrée cmd^{∗}, c̅m̅d̅^{∗} sont sensiblement complémentaires l'un de l'autre. Les signaux de commande d'entrée cmd, c̅m̅d̅^{∗} sont respectivement amplifiés par les amplificateurs 264, 266 pour respectivement obtenir des signaux de commande de sortie CMD^{∗}, C̅M̅D̅^{∗} fournis aux interrupteurs 222, 224, pour que la machine électrique tournante 104 puisse fonctionner en mode moteur ou en mode alternateur suivant le mode dans lequel fonctionne le microcontrôleur 242.

Le dispositif de gestion de commandes 262 est en outre conçu pour recevoir une commande d'inhibition partielle INHIB_P et, tant que la commande d'inhibition partielle INHIB_P est reçue, pour fonctionner dans un mode dit alternateur dégradé, dans lequel le dispositif de gestion de commandes 262 est conçu pour établir lui-même, c'est-à-dire indépendamment des commandes cmd et de la sélection de mode MS reçues du microcontrôleur 242, les signaux de commande d'entrée cmd^{∗}, c̅m̅d̅^{∗} fournis aux amplificateurs 264, 266. Les signaux de commande d'entrée cmd, c̅m̅d̅^{∗} sont à nouveau amplifiés par les amplificateurs 264, 266 pour respectivement obtenir les signaux de commande de sortie CMD^{∗}, C̅M̅D̅^{∗} fournis aux interrupteurs 222, 224, pour que la machine électrique tournante 104 puisse fonctionner en mode alternateur.

Le pilote 260 comporte en outre une entrée d'inhibition partielle 270 connectées aux dispositifs 252, 258 de manière à recevoir la commande d'inhibition partielle INHIB_P fournie par n'importe lequel de ces dispositifs 252, 258. Cette entrée d'inhibition partielle 270 est en outre connectée au dispositif de gestion de commandes 262 du pilote 260 pour lui fournir chaque commande d'inhibition partielle INHIB_P reçue, afin de passer en mode alternateur dégradé.

Le pilote 260 comporte en outre une entrée d'inhibition totale 268 connectée aux dispositifs de surveillance 254, 240 de manière à recevoir la commande d'inhibition totale INHIB_T fournie par n'importe lequel de ces dispositifs 254, 240. Tant qu'une commande d'inhibition totale INHIB_T est reçue sur l'entrée d'inhibition totale 268, le pilote 260 est conçu pour fournir des signaux de commande de sortie CMD^{∗}, C̅M̅D̅^{∗} maintenant les interrupteurs 222, 224 ouverts, indépendamment des commandes cmd reçues du microcontrôleur 242. La manière dont cette fonction est réalisée sera expliquée plus loin, en référence à la figure 3.

Le système de commande 108 comporte en outre une puce de base système (de l'anglais « System Basis Chip » ou SBC) 238 connectée au bus de données 204 et à la source de tension continue 206 (par exemple par l'entrée 232) pour recevoir la tension V_{BAT1}. La puce de base système 238 est conçue pour réaliser plusieurs fonctions parmi lesquelles la fourniture d'une ou plusieurs tension d'alimentation, notamment du microcontrôleur 242 et du pilote 260, à partir de la tension V_{BAT1}, la transmission des messages entre le bus de données 204 et le microcontrôleur 242 et la surveillance du microcontrôleur 242. Pour réaliser cette dernière fonction, la puce de base système 238 comporte le dispositif de surveillance 240.

Il sera apprécié que la tension V_{BAT1} est utilisée pour l'alimentation du pilote 260 et du microcontrôleur 242. Ainsi, la sous-tension de la tension V_{BAT1} est une défaillance critique pour le système de commande 108. C'est pourquoi le dispositif de surveillance 254 fournit une commande d'inhibition totale INHIB_T destinée à tout le temps maintenir les interrupteurs 222, 224 ouverts. En revanche, une sous-tension de la tension V_{BFT} est moins critique (en tout cas pour le système de commande 108), de sorte que le mode alternateur dégradé peut être gardé. C'est pourquoi la commande d'inhibition du dispositif 252 est fournie à l'entrée d'inhibition partielle 270 du pilote 260.

En référence à la figure 3, les éléments réalisant la fonction d'inhibition totale vont à présent être décrits.

Comme illustré sur la figure 3, l'amplificateur de côté haut 264, respectivement de côté bas 266, est conçu pour recevoir le signal de commande d'entrée cmd^{∗}, respectivement c̅m̅d̅^{∗}, pour amplifier ce signal de commande d'entrée cmd^{∗}, respectivement c̅m̅d̅^{∗}, pour obtenir le signal de commande de sortie CMD^{∗}, respectivement C̅M̅D̅^{∗}, et pour appliquer le signal de commande de sortie CMD^{∗}, respectivement C̅M̅D̅^{∗}, à l'interrupteur de côté haut 222, respectivement de côté bas 224, pour sélectivement l'ouvrir et le fermer.

Chaque amplificateur 264, 266 présente deux bornes d'alimentation positive (notée + sur la figure 3) et négative (noté - sur la figure 3) destinées à recevoir une tension d'alimentation de cet amplificateur 264, 266. La borne d'alimentation négative est connectée à la borne de sortie de courant de l'amplificateur de côté haut 222, respectivement de côté bas 224.

Le pilote 260 comporte en outre deux capacités d'amorçage 302, 304 (de l'anglais « bootstrap capacitor ») connectées entre les bornes positive et négative respectivement des amplificateurs 264, 266 pour fournir les tensions d'alimentation respectives.

Le pilote 260 comporte en outre deux dispositifs de charge 306, 308 respectivement des deux capacités d'amorçage 302, 304 à partir d'une tension, la tension V_{BAT1} dans l'exemple décrit. Le dispositif de charge 306 comporte par exemple une pompe de charge. Cette dernière comporte par exemple une capacité 309 connectée à la tension V_{BAT1} et à la capacité 302 par l'intermédiaire de quatre interrupteurs 311₁, 311₂, 311₃, 311₄. Ces derniers sont commandés pour alternativement connecter la capacité 309 à la tension V_{BAT1} et à la capacité d'amorçage 302. Le dispositif de charge 308 comporte par exemple une diode 313 permettant le passage de courant depuis la tension V_{BAT1} vers la capacité d'amorçage 304.

Le pilote 260 comporte en outre un dispositif d'inhibition 310 de l'amplificateur de côté haut 264. Le dispositif d'inhibition 310 est connecté à l'entrée d'inhibition totale 268 pour recevoir une commande d'inhibition totale INHIB_T et est conçu, sur réception de la commande d'inhibition totale INHIB_T, pour faire baisser la tension d'alimentation entre les bornes d'alimentation de l'amplificateur de côté haut 364, de sorte que le signal de commande de sortie CMD^{∗} provoque l'ouverture de l'interrupteur de côté haut 222, quel que soit le signal de commande d'entrée cmd^{∗} reçu.

Dans l'exemple décrit, le dispositif d'inhibition 310 est conçu, sur réception de la commande d'inhibition totale INHIB_T, pour mettre les bornes d'alimentation de l'amplificateur de côté haut 264 en court-circuit, ce qui décharge la capacité d'amorçage 302 et fait baisser la tension d'alimentation de l'amplificateur de côté haut 264. Par exemple, le dispositif d'inhibition 310 est conçu pour annuler cette tension d'alimentation. La diminution de la tension d'alimentation entraîne la diminution du signal de commande de sortie CMD^{∗}, de sorte qu'à un moment ce signal de commande de sortie CMD^{∗} ne soit plus suffisant, même à son maximum, pour provoquer la fermeture de l'interrupteur de côté haut 222. Ce dernier reste ainsi ouvert.

Plus précisément, dans l'exemple décrit, le dispositif d'inhibition 310 comporte un interrupteur commandable de court-circuit, présentant une borne d'entrée de courant connectée à la borne d'alimentation positive, une borne de sortie de courant connectée à la borne d'alimentation négative, et une borne de commande. En outre, le pilote 260 comporte un dispositif de décalage de niveau 312 (de l'anglais « level shifter ») connecté entre l'entrée d'inhibition totale 268 et le dispositif d'inhibition 310. L'interrupteur commandable de court-circuit est par exemple un transistor à effet de champ à grille isolée (de l'anglais « Metal Oxide Semiconductor Field Effect Transistor » ou MOSFET).

Chaque commande d'inhibition totale INHIB_T appliquée à l'entrée d'inhibition totale 268 est sous la forme d'une tension par rapport à la masse électrique GND2. Le dispositif de décalage de niveau 312 est conçu pour recevoir cette tension et pour la décaler de manière à fournir la commande d'inhibition totale INHIB_T sous la forme d'une tension entre la borne de commande de l'interrupteur commandable de court-circuit et la borne négative de l'amplificateur de côté haut 264.

De manière similaire, pour l'inhibition de l'amplificateur de côté bas 266, le pilote 260 comporte un dispositif d'inhibition 314 et un dispositif de décalage de niveau 316.

D'après ce qui précède, il apparait que la fonction d'inhibition totale des interrupteurs 222, 224 est indépendante des signaux de commande d'entrée cmd^{∗}, c̅m̅d̅^{∗} reçus par les amplificateurs 264, 266. Ainsi, en cas de défaillance du dispositif de gestion de commandes 262, il est toujours possible d'ouvrir les deux interrupteurs 222, 224. En outre, la solution décrite utilise un nombre réduit de composants, qui sont des plus simples, de sorte que l'inhibition est rapide. Dans l'exemple décrit, le temps entre l'application d'une commande totale d'inhibition INHIB_T sur l'entrée d'inhibition totale 268 et l'inhibition effective des amplificateurs 264, 266 est inférieure à 500 µs, par exemple 400 µs Or, le délai généralement souhaité entre la survenue d'une défaillance et l'ouverture des interrupteurs 222, 224 est d'environ 1 ms. Ainsi, le délai de 400 µs de mise en œuvre de la commande d'inhibition laisse 600 µs pour la détection de la défaillance, ce qui est généralement suffisant.

La présente invention n'est pas limitée au mode de réalisation décrit précédemment. Il sera en effet apparent à l'homme du métier que des modifications peuvent y être apportées.

Par exemple, au moins un des dispositifs de surveillance 252, 254 pourrait être réalisé à l'extérieur du microcontrôleur 242, dans un ou plusieurs composants précablés (c'est-à-dire ne mettant pas en œuvre de programme d'ordinateur).

En outre, de manière générale, chacun des dispositifs de surveillance 246, 248, 252, 254, 256 peut être connecté soit à l'entrée d'inhibition totale 268 pour entraîner l'ouverture des interrupteurs 222, 224 (que le microcontrôleur 242 soit en mode moteur ou bien en mode alternateur), soit à l'entrée d'inhibition partielle 270 pour passer le pilote en mode alternateur dégradé.

## Revendications

1. Système de commande d'un interrupteur (222 ; 224), comportant :
- un amplificateur (264; 266) conçu pour recevoir un signal de commande d'entrée (cmd^{∗}; c̅m̅d̅^{∗}), pour amplifier le signal de commande d'entrée (cmd^{∗}; c̅m̅d̅^{∗}) afin d'obtenir un signal de commande de sortie (CMD^{∗}; C̅M̅D̅^{∗}) et pour appliquer le signal de commande de sortie (CMD^{∗}; C̅M̅D̅^{∗}) à l'interrupteur (222 ; 224) pour sélectivement ouvrir et fermer l'interrupteur (222 ; 224), l'amplificateur (264; 266) présentant deux bornes d'alimentation positive et négative destinées à recevoir une tension d'alimentation, **caractérisé en ce qu'**il comporte en outre :
- un dispositif d'inhibition (310; 314) de l'amplificateur (264; 266) conçu, sur réception d'une commande d'inhibition dite totale (INHIB_T), pour faire baisser la tension d'alimentation de sorte que le signal de commande de sortie (CMD^{∗}; C̅M̅D̅^{∗}) maintienne l'interrupteur (222 ; 224) ouvert quel que soit le signal de commande d'entrée (cmd^{∗}; c̅m̅d̅^{∗}).

2. Système de commande selon la revendication 1, dans lequel le dispositif d'inhibition (310; 314) est conçu, sur réception de la commande d'inhibition totale (INHIB_T), pour mettre les bornes d'alimentation de l'amplificateur (264 ; 266) en court-circuit.

3. Système de commande selon la revendication 1 ou 2, dans lequel le dispositif d'inhibition (310; 314) comporte un interrupteur commandable de court-circuit présentant une borne d'entrée de courant connectée à la borne d'alimentation positive, une borne de sortie de courant connectée à la borne d'alimentation négative, et une borne de commande, la commande d'inhibition totale (INHIB_T) étant sous la forme d'une tension entre la borne de commande et la borne de sortie de courant.

4. Système de commande selon l'une quelconque des revendications 1 à 3, comportant en outre un dispositif de décalage de niveau (312 ; 316) conçu pour recevoir la commande d'inhibition totale (INHIB_T) sous la forme d'une tension par rapport à une référence de tension différente de la borne négative de l'amplificateur (264; 266) et pour fournir la commande d'inhibition totale (INHIB_T) au dispositif d'inhibition (310 ; 314) sous la forme d'une tension par rapport à la borne négative de l'amplificateur (264 ; 266).

5. Système de commande selon l'une quelconque des revendications 1 à 4, comportant en outre une capacité (302; 304) connectée entre les bornes positive et négative de l'amplificateur pour fournir la tension d'alimentation.

6. Système de commande selon la revendication 5, comportant en outre un dispositif de charge (306 ; 308) de la capacité (302 ; 304).

7. Système de bras de commutation (220) d'un convertisseur de tension (106), comportant :
- un interrupteur de côté haut (222),
- un interrupteur de côté bas (224),
- un système de commande de l'un parmi les interrupteurs de côté haut (222) et de côté bas (224), selon l'une quelconque des revendications 1 à 6,
dans lequel l'interrupteur de côté haut (222) et l'interrupteur de côté bas (224) sont connectés l'un à l'autre en un point milieu destiné à être connecté à une phase d'une machine électrique tournante (104).

8. Système de bras de commutation (220) selon la revendication 7, comportant en outre un système de commande de l'autre parmi les interrupteurs de côté haut (222) et de côté bas (224), selon l'une quelconque des revendications 1 à 6.

9. Système de bras de commutation selon la revendication 8, comportant une seule entrée (268) de réception de la commande d'inhibition totale (INHIB_T) destinée à la fois au système de commande de l'interrupteur de côté haut (222) et au système de commande de l'interrupteur de côté bas (224).

## Patentansprüche

1. System zur Steuerung eines Schalters (222; 224), das umfasst:
- einen Verstärker (264; 266), der dazu gedacht ist, ein Eingangsbefehlssignal (cmd*; c̅m̅d̅*) zu empfangen, um das Eingangsbefehlssignal (cmd*; c̅m̅d̅*) zu verstärken, um ein Ausgangsbefehlssignal (CMD*; C̅M̅D̅*) zu erhalten und um das Ausgangsbefehlssignal (CMD*; C̅M̅D̅*) an den Schalter (222; 224) anzulegen, um den Schalter (222; 224) selektiv zu öffnen und zu schließen, wobei der Verstärker (264; 266) zwei Versorgungsanschlüsse, positiv und negativ, aufweist, die dazu bestimmt sind, eine Versorgungsspannung zu empfangen,
**dadurch gekennzeichnet, dass** es außerdem umfasst:
- eine Inhibitionsvorrichtung (310; 314) des Verstärkers (264; 266), die dazu gedacht ist, bei Empfang eines sogenannten Totalinhibitionsbefehls (INHIB_T) die Versorgungsspannung absinken zu lassen, so dass das Ausgangsbefehlssignal (CMD*; C̅M̅D̅*) den Schalter (222; 224) den Schalter ungeachtet des Eingangsbefehlssignals (cmd*; c̅m̅d̅*) offen hält.

2. Steuerungssystem nach Anspruch 1, wobei die Inhibitionsvorrichtung (310; 314) dazu gedacht ist, bei Empfang des Totalinhibitionsbefehls (INHIB_T) die Versorgungsanschlüsse des Verstärkers (264; 266) kurzzuschließen.

3. Steuerungssystem nach Anspruch 1 oder 2, wobei die Inhibitionsvorrichtung (310; 314) einen durch Kurzschluss steuerbaren Schalter umfasst, der einen mit dem positiven Versorgungsanschluss verbundenen Eingangsstromanschluss, einen mit dem negativen Versorgungsanschluss verbundenen Ausgangsstromanschluss und einen Steueranschluss aufweist, wobei der Totalinhibitionsbefehl (INHIB_T) in Form einer Spannung zwischen dem Steueranschluss und dem Ausgangsstromanschluss vorliegt.

4. Steuerungssystem nach einem der Ansprüche 1 bis 3, das außerdem eine Pegelumsetzervorrichtung (312; 316) umfasst, die dazu gedacht ist, den Totalinhibitionsbefehl (IMHIB_T) in Form einer Spannung bezüglich einer anderen Referenzspannung des negativen Anschlusses des Verstärkers (264; 266) zu empfangen und um den Totalinhibitionsbefehl (INHIB_T) in Form einer Spannung bezüglich des negativen Anschlusses des Verstärkers (264; 266) an die Inhibitionsvorrichtung (310; 314) zu liefern.

5. Steuerungssystem nach einem der Ansprüche 1 bis 4, das außerdem einen Kondensator (302; 304) umfasst, der zwischen den positiven und den negativen Anschluss des Verstärkers geschaltet ist, um die Versorgungsspannung zu liefern.

6. Steuerungssystem nach Anspruch 5, das außerdem eine Ladevorrichtung (306; 308) des Kondensators (302; 304) umfasst.

7. Schaltarmsystem (220) eines Spannungswandlers (106), das umfasst:
- einen hochseitigen Schalter (222),
- einen niederseitigen Schalter (224),
- ein Steuerungssystem eines von dem hochseitigen (222) und dem niederseitigen Schalter (224) nach einem der Ansprüche 1 bis 6,
wobei der hochseitige Schalter (222) und der niederseitige Schalter (224) miteinander in einem Mittelpunkt verbunden sind, der dazu bestimmt ist, mit einer Phase einer drehenden elektrischen Maschine (104) verbunden zu werden.

8. Schaltarmsystem (220) nach Anspruch 7, das außerdem ein Steuerungssystem des anderen von dem hochseitigen (222) und niederseitigen Schalter (224) nach einem der Ansprüche 1 bis 6 umfasst.

9. Schaltarmsystem nach Anspruch 8, das einen einzigen Eingang (268) zum Empfang des Totalinhibitionsbefehls (INHIB_T) umfasst, der gleichzeitig für das Steuerungssystem des hochseitigen Schalters (222) und für das Steuerungssystem des niederseitigen Schalters (224) bestimmt ist.

## Claims

1. Control system for a switch (222; 224), comprising:
- an amplifier (264; 266) designed to receive an input control signal (cmd*; c̅m̅d̅*), in order to amplify the input control signal (cmd*; c̅m̅d̅*) so as to obtain an output control signal (CMD*; C̅M̅D̅*) and to apply the output control signal (CMD*; C̅M̅D̅*) to the switch (222; 224) in order to either open or close the switch (222; 224), the amplifier (264; 266) having two, positive and negative, supply terminals intended to receive a supply voltage,
**characterized in that** it moreover comprises:
- an inhibiting device (310; 314) for the amplifier (264; 266) designed to lower the supply voltage on receiving what is referred to as a total inhibit control (INHIB_T) so that the output control signal (CMD*; C̅M̅D̅*) keeps the switch (222; 224) open irrespective of the input control signal (cmd*; c̅m̅d̅*).

2. Control system according to Claim 1, in which the inhibiting device (310; 314) is designed to short the supply terminals of the amplifier (264; 266) on receiving the total inhibit control (INHIB_T).

3. Control system according to Claim 1 or 2, in which the inhibiting device (310; 314) comprises a controllable shorting switch having a current input terminal connected to the positive supply terminal, a current output terminal connected to the negative supply terminal, and a control terminal, the total inhibit control (INHIB_T) being in the form of a voltage between the control terminal and the current output terminal.

4. Control system according to any one of Claims 1 to 3, moreover comprising a level shifter (312; 316) designed to receive the total inhibit control (INHIB_T) in the form of a voltage with respect to a voltage reference different than the negative terminal of the amplifier (264; 266) and to provide the total inhibit control (INHIB_T) to the inhibiting device (310; 314) in the form of a voltage with respect to the negative terminal of the amplifier (264; 266).

5. Control system according to any one of Claims 1 to 4, moreover comprising a capacitor (302; 304) connected between the positive and negative terminals of the amplifier in order to provide the supply voltage.

6. Control system according to Claim 5, moreover comprising a charging device (306; 308) for the capacitor (302; 304) .

7. Switching arm system (220) for a voltage converter (106), comprising:
- a high-side switch (222),
- a low-side switch (224),
- a control system for one of the high-side (222) and low-side (224) switches, according to any one of Claims 1 to 6,
in which the high-side switch (222) and the low-side switch (224) are connected to one another at a midpoint intended to be connected to one phase of a rotating electrical machine (104).

8. Switching arm system (220) according to Claim 7, moreover comprising a control system for the other of the high-side (222) and low-side (224) switches, according to any one of Claims 1 to 6.

9. Switching arm system according to Claim 8, comprising a single reception input (268) for the total inhibit control (INHIB_T) intended both for the control system for the high-side switch (222) and for the control system for the low-side switch (224).
